# DEMANDE DE BREVET EUROPEEN

(11) **EP 4 391 053 A1**
(43) Date de publication de la demande: **26.06.2024**
(21) Numéro de dépôt: 23217208.0
(22) Date de dépôt: 15.12.2023
(51) Int. Cl.: H01L 25/16, H01L 21/98, H01G 2/06, H01G 4/10, H01G 4/228, H01G 4/33, H01G 4/40, C25D 11/02, H01L 23/50, H01L 23/64

(54) **DISPOSITIF ELECTRONIQUE**

(30) Priorité: 19.12.2022 FR 2213881
(71) Demandeur: Commissariat à l'énergie atomique et aux énergies alternatives, 75015 Paris (FR)
(72) Inventeur: LAVIRON, Cyrille, 38054 GRENOBLE CEDEX 09 (FR); DUPRE, Cécilia, 38054 GRENOBLE CEDEX 09 (FR); LEFEVRE, Aude, 38054 GRENOBLE CEDEX 09 (FR); LAMY, Yann, 38054 GRENOBLE CEDEX 09 (FR)
(74) Mandataire: Thibon, Laurent

(57) **Abrégé**

La présente description concerne un dispositif comprenant des première (20) et deuxième (36) puces, la première puce (20) comprenant un circuit électronique et la deuxième puce (36) comprenant un condensateur (18) ayant une densité supérieure à 700 nF/mm^2, les première et deuxième puces étant fixées l'une à l'autre par collage moléculaire.

## Description

### Domaine technique

La présente description concerne de façon générale les dispositifs électroniques et leurs procédés de fabrication.

### Technique antérieure

Il existe un besoin de placer des condensateurs proches de circuits électroniques, de manière à optimiser la fourniture de puissance aux circuits électroniques. En particulier, il existe un besoin de réduire significativement les inductances équivalentes (ESL) et les résistances équivalentes (ESR) parasites, de manière à augmenter grandement l'efficacité des circuits. De manière conventionnelle, la connexion des condensateurs, par exemple discrets, sur une puce active se fait par connexion filaire ou par billes métalliques ayant des dimensions comprises entre 100 µm et 1 mm. Ces connexions génèrent elles-mêmes des inductances (5 à 100 pH) et/ou des résistances (20-100 mOhms) parasites. Ces inductances ou résistances parasites sont équivalentes ou dépassent même les inductances ou résistances parasites des condensateurs très haute performance (1 pF/mm2) .

### Résumé de l'invention

Il existe un besoin d'interconnexions très étroites de capacités de très hautes performances, c'est-à-dire ayant une haute valeur et de faibles valeurs de ESR et ESL, avec des dispositifs actifs, par exemple, des transistors, de plus en plus intégrés et sensibles à la qualité de l'alimentation en puissance et en courant. Les solutions classiques de report de capacités sur circuits imprimés ou dans les boîtiers ne répondent plus au besoin, qui demande une intégration de densité très dense, au plus près des transistors, avec donc des densités de connexion très élevées.

Un mode de réalisation pallie tout ou partie des inconvénients des procédés de fabrication de puce comprenant des condensateurs connus.

Un mode de réalisation prévoit un dispositif comprenant des première et deuxième puces, la première puce comprenant un circuit électronique et la deuxième puce comprenant un condensateur ayant une densité supérieure à 700 nF/mm^2, les première et deuxième puces étant fixées l'une à l'autre par collage moléculaire.

Un autre mode de réalisation prévoit un procédé comprenant la formation d'une première puce comprenant un circuit électronique, et la formation d'une deuxième puce comprenant un condensateur ayant une densité supérieure à 700 nF/mm^2, le procédé comprenant en outre la fixation des première et deuxième puces par collage moléculaire.

Selon un mode de réalisation, la première puce comprend un réseau d'interconnexion et un substrat semiconducteur dans et sur lequel sont situés des composants du circuit électronique.

Selon un mode de réalisation, le condensateur comprend un empilement d'une première couche isolante entre deux deuxièmes couches conductrices, l'empilement étant situé dans une première région de métal anodisé.

Selon un mode de réalisation, la deuxième puce comprend une troisième couche isolante ayant une première face plane et une deuxième face, la deuxième face étant recouverte d'une quatrième couche comprenant au moins la première région.

Selon un mode de réalisation, la première région est entourée d'une quatrième région isolante en métal anodisé.

Selon un mode de réalisation, le procédé comprend la formation, sur un support, de la troisième couche isolante et d'une couche de métal anodisable.

Selon un mode de réalisation, la quatrième couche de la deuxième puce comprend des deuxièmes régions isolantes en métal anodisé et des troisièmes régions en métal, les troisièmes régions étant séparées par des deuxièmes régions.

Selon un mode de réalisation, le procédé comprend l'anodisation de la couche métallique aux emplacements des première et deuxième régions.

Selon un mode de réalisation, le procédé comprend la fixation de la première puce à une poignée et le retrait du support de manière à découvrir la face plane de la troisième couche.

Selon un mode de réalisation, les première et deuxième puces sont fixées par collage moléculaire hybride, la troisième couche isolante et le réseau d'interconnexion comprenant des premières pistes conductrices situées en contact les unes avec les autres.

Selon un mode de réalisation, la face du substrat opposée au réseau d'interconnexion est recouverte par une cinquième couche isolante et des deuxièmes pistes conductrices, la cinquième couche et les deuxièmes pistes conductrices étant configurées pour être fixées à la troisième couche et aux premières pistes par collage moléculaire.

Selon un mode de réalisation, les puces sont fixées par collage moléculaire oxyde/oxyde, le dispositif comprenant des vias s'étendant dans les première et deuxième puces, traversant la troisième couche et atteignant une piste conductrice enterrée dans le réseau d'interconnexion.

Selon un mode de réalisation, les vias sont formés après la fixation des première et deuxième puces.

Selon un mode de réalisation, chacune des bornes du condensateur est reliée à une troisième région.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un mode de mise en oeuvre d'un procédé de fabrication d'un mode de réalisation d'un dispositif comprenant un condensateur proche d'un circuit électronique ;
la figure 2 représente un mode de réalisation d'un dispositif comprenant un condensateur proche d'un circuit électronique ;
la figure 3 représente une étape d'un mode de mise en oeuvre du procédé de la figure 1 ;
la figure 4 représente une autre étape d'un mode de mise en oeuvre du procédé de la figure 1 ;
la figure 5 représente une autre étape d'un mode de mise en oeuvre du procédé de la figure 1 ;
la figure 6 représente une autre étape d'un mode de mise en oeuvre du procédé de la figure 1 ;
la figure 7 représente une autre étape d'un mode de mise en oeuvre du procédé de la figure 1 ;
la figure 8 représente une autre étape d'un mode de mise en oeuvre du procédé de la figure 1 ;
la figure 9 représente un mode de réalisation d'un dispositif comprenant un condensateur proche d'un circuit électronique résultant d'un autre mode de mise en oeuvre ; et
la figure 10 représente un mode de réalisation d'un dispositif comprenant un condensateur proche d'un circuit électronique résultant d'un autre mode de mise en oeuvre.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

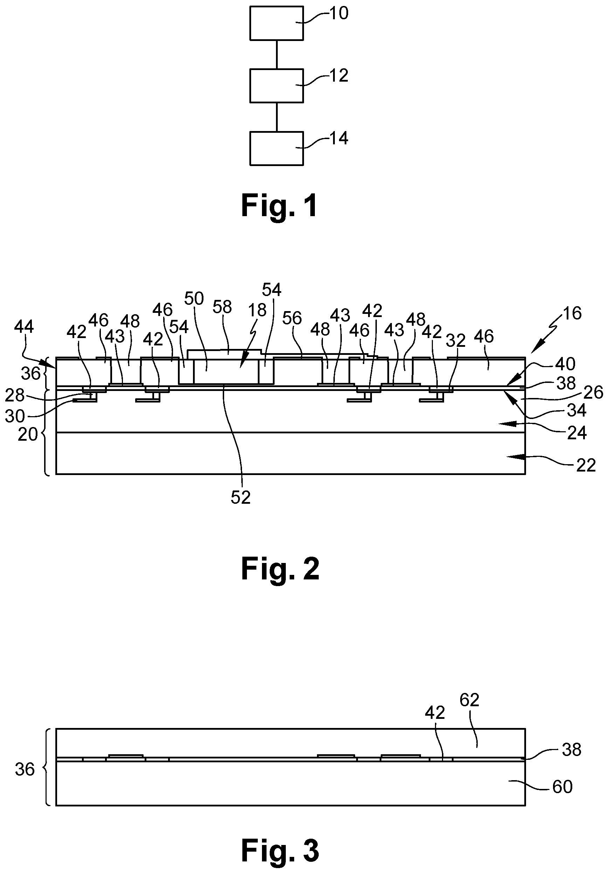

La figure 1 représente schématiquement un mode de mise en oeuvre d'un procédé de fabrication d'un mode de réalisation d'un dispositif comprenant un condensateur proche d'un circuit électronique.

Le procédé comprend une étape 10 au cours de laquelle une première puce est formée. La première puce comprend un circuit électronique. La première puce comprend par exemple des transistors. La première puce comprend de préférence un substrat semiconducteur, dans et sur lequel sont formés des transistors, et un réseau d'interconnexion. Le réseau d'interconnexion comprend par exemple des couches isolantes et un réseau de pistes conductrices et de vias conducteurs. La première puce comprend une face plane, adaptée au collage moléculaire.

Le procédé comprend une étape 12 au cours de laquelle une deuxième puce est formée. La deuxième puce comprend au moins un condensateur de type Métal-Isolant-Métal, c'est-à-dire un condensateur comprenant un empilement d'une couche isolante et de deux couches métalliques, la couche isolante étant située entre les couches métalliques. L'empilement du condensateur est situé sur une couche de métal comprenant au moins une région anodisée. Ladite région de la couche de métal comprend une pluralité de cavités, ou nanopores, l'empilement formant le condensateur s'étendant sur les parois et le fond des cavités et sur les portions de la couche entre les cavités.

De préférence, la deuxième puce ne comprend pas d'autres composants électroniques actifs que des condensateurs, et éventuellement des résistances. Par exemple, la deuxième puce ne comprend pas de transistor. Par exemple la deuxième puce ne comprend pas de substrat semiconducteur.

La deuxième puce comprend une face plane, adaptée au collage moléculaire.

Les étapes 10 et 12 peuvent être effectuées indépendamment, par exemple successivement ou en parallèle.

Le procédé comprend en outre une étape 14 au cours de laquelle les première et deuxième puces sont fixées l'une à l'autre par collage moléculaire. Plus précisément, les faces planes des première et deuxième puces sont fixées l'une à l'autre par collage moléculaire.

La figure 2 représente un mode de réalisation d'un dispositif 16 comprenant un condensateur 18, et éventuellement des résistances non représentées, proche d'un circuit électronique. Le dispositif 16 est obtenu par un procédé tel que celui décrit en relation avec la figure 1.

Le dispositif 16 comprend une puce 20. La puce 20, comme la première puce de la figure 1, comprend un substrat semiconducteur 22. Des composants électroniques, par exemple des transistors, sont situés dans et sur le substrat 22. La puce 20 comprend en outre un réseau d'interconnexion 24. Le réseau d'interconnexion 24 comprend des couches isolantes 26, les séparations des différentes couches n'étant pas représentées en figure 2. Le réseau d'interconnexion 24 comprend en outre des vias conducteurs 28 et des pistes conductrices 30. Le réseau 24 comprend des pistes 32 métalliques affleurant une face 34 du réseau 24. La face 34 est la face la plus éloignée du substrat 22, autrement dit la face opposée à la face du réseau 24 en contact avec le substrat 22. Les pistes 32 sont adaptées à une étape de collage moléculaire hybride.

Les vias 28 et les pistes 30, 32 permettent de former des connexions électriques entre des composants électroniques de la puce 20 et d'autres composants de la puce 20 ou des composants externes à la puce, par exemple le condensateur 18.

Le dispositif 16 comprend en outre une puce 36. La puce 36 correspond à la deuxième puce de la figure 1. La puce 36 comprend un condensateur 18, et éventuellement des résistances. Bien qu'un seul condensateur 18 est représenté en figure 2, la puce 36 peut comprendre plusieurs condensateurs 18.

La puce 36 comprend une couche isolante 38. La couche 38 a par exemple une épaisseur comprise entre 10 nm et 1 µm. La couche isolante 38 comprend une face 40. La puce 36 comprend en outre des pistes métalliques 42 dans la couche 38. Les pistes métalliques 42 affleurent la face 40 de la couche 38. De préférence, les pistes 42 traversent la piste 38. Autrement dit, les pistes 42 ont de préférence la même épaisseur que la couche 38. La face 40 de la couche 38 est fixée par collage moléculaire hybride avec la face 34 de la puce 20. Ainsi, chaque piste 42 est de préférence situé de manière à être en contact avec une piste 32. Des connexions entre la puce 20 et la puce 36 sont ainsi faites par l'intermédiaire des pistes 32 et 42.

La puce 36 comprend en outre des éléments 43 en matériau isolant, par exemple en le même matériau que la couche 38. Les éléments 43 sont situés sur la couche 38, plus précisément sur la face opposée à la face 40. Les éléments 43 ne recouvrent de préférence pas, même partiellement, les pistes 42. Les éléments 43 recouvrent certaines parties de la couche 38. Les éléments 43 ne recouvrent pas entièrement la couche 38. Les éléments 43 ont par exemple une épaisseur comprise entre 300 nm et 3 µm.

La puce 36 comprend une couche 44. La couche 44 est située sur la couche 38, sur les pistes 42 et sur les éléments 43. Plus précisément, la couche 44 recouvre la face opposée à la face 40 de la couche 38. La couche 44 a par exemple une épaisseur inférieure à 20 µm, par exemple sensiblement égale à 10 µm.

La couche 44 comprend des régions 46. Les régions 46 sont des régions conductrices. Les régions 46 sont en un matériau conducteur anodisable, de préférence en métal. Les régions 46 sont par exemple en aluminium ou en tantale. Chaque piste 42 est de préférence recouverte par, de préférence en contact avec, une région 46.

Les régions 46 s'étendent, au moins dans certaines parties de la couche 44, sur toute la hauteur de la couche 44. Les régions 46 s'étendent donc de la face supérieure de la couche 20, à la face supérieure de la couche 44. Chaque région 46 permet de continuer la liaison électrique de la piste 42 avec laquelle la région 46 est en contact.

Les régions 46 sont par exemple entourées par des régions 48 de la couche 44. Les régions 48 sont des régions isolantes. Les régions 48 sont en le matériau des régions 46, par exemple en aluminium, ayant été anodisées, par exemple de manière à obtenir de l'alumine. Les régions 48 sont ainsi des régions poreuses. Autrement dit, les régions 48 comprennent une pluralité de cavités, ou nanopores, non représentées, s'étendant par exemple sur toute la hauteur de la région 48.

Les régions 48 sont situées sur les éléments 43. De préférence, chaque élément 43 est au moins partiellement, par exemple majoritairement, recouvert par une région 48. De préférence, chaque région 48 recouvre un élément 43. Les éléments 43 et les régions 48 permettent de former une isolation latérale dans la couche 44.

La couche 44 comprend en outre une ou plusieurs des régions 50, dans lesquelles sont situés des condensateurs 18. Chaque région 50 comprend par exemple un unique condensateur 18. Dans l'exemple de la figure 2, la couche 44 ne comprend qu'un unique condensateur 18, et une seule région 50. Le condensateur 18 est un condensateur haute densité, c'est-à-dire un condensateur ayant une densité supérieure à 700 nF/mm^2, par exemple supérieure à 1 µF/mm^2.

La région 50 s'étend en regard d'une partie de la couche 38 non recouverte d'éléments 43. Ainsi, la région 50 n'est pas en regard, même partiellement, d'un élément 43. La région 50 s'étend depuis la face supérieure de la couche 44, c'est-à-dire la face la plus éloignée de la couche 38. La région 50 affleure donc la face supérieure de la couche 44. La région 50 ne s'étend par exemple pas jusqu'à la couche 38. De préférence, la hauteur de la région 50 est sensiblement égale à la hauteur des parties des régions 46 situées en contact avec les éléments 43. Ainsi, la région 50 est séparée de la couche 38, par exemple par une distance sensiblement égale à la hauteur des régions 43. De préférence, la région 50 est séparée de la couche 38 par une portion 52 conductrice, par exemple une couche en aluminium ou en un alliage comprenant de l'aluminium recouverte d'une couche en tungstène constituant une couche d'arrêt à l'anodisation de la région 50.

La région 50 est, comme les régions 48, en le matériau des régions 46, par exemple en aluminium, ayant été anodisées, par exemple de manière à obtenir de l'alumine. La région 50 comprend ainsi une pluralité de cavités non représentées, s'étendant par exemple sur toute la hauteur de la région 50. La densité de cavités dans la région 50 est par exemple supérieure à 40 cavités/µm^2.

Le condensateur 18 est un condensateur Métal-isolant-métal ou MIM. Le condensateur 18 comprend un empilement de couches, non représenté en figure 1, d'une couche isolante située entre deux couches conductrices, de préférence en métal. L'empilement de couches d'un condensateur 18 est situé de manière conforme sur la structure poreuse de la région 50.

Une couche inférieure de l'empilement du condensateur 18, c'est-à-dire une des couches conductrices, de préférence une couche métallique, s'étend de manière conforme sur la structure poreuse, et en particulier dans les cavités de la région 50. La couche inférieure d'un condensateur 18 recouvre, de préférence entièrement, la face supérieure de la région 50, les parois latérales des cavités, et le fond des cavités. La couche inférieure d'un condensateur 18 est donc en contact avec la portion 52.

Une couche intermédiaire de l'empilement d'un condensateur 18, c'est-à-dire la couche isolante, s'étend de manière conforme sur la couche inférieure. La couche intermédiaire s'étend dans les cavités. La couche intermédiaire recouvre de préférence entièrement la couche inférieure.

Une couche supérieure de l'empilement d'un condensateur 18, c'est-à-dire l'autre couche conductrice, par exemple en métal, s'étend de manière conforme sur la couche intermédiaire. La couche supérieure s'étend dans les cavités. La couche supérieure remplit par exemple les cavités. La couche supérieure recouvre de préférence entièrement la couche intermédiaire. La couche supérieure comprend par exemple une face supérieure plane s'étendant au-dessus de la face supérieure de la structure poreuse.

La couche 44 comprend par exemple une ou plusieurs régions 54 isolantes délimitant la région 50. La région 50 est entourée de régions 54. La région 50 est ainsi isolée latéralement du reste de la couche 44. La région 50 est de préférence directement en contact latéral avec les régions 54. Ainsi, la région 50 n'est de préférence pas séparée des régions 54 par d'autres régions de la couche 44. En particulier, la région 50 n'est de préférence pas séparée des régions 54 par des régions du matériau des régions 46 n'ayant pas été anodisé et n'étant pas poreux.

Les régions 54 sont des régions isolantes. Les régions 54 sont en le matériau de la couche 44, par exemple en aluminium ayant été anodisé, par exemple en alumine. Les régions 54 sont ainsi des régions poreuses. Autrement dit, les régions 54 comprennent une pluralité de cavités non représentées, s'étendant par exemple sur toute la hauteur de la région 54. De préférence, la hauteur des régions 54 est sensiblement égale à la hauteur de la région 50. Les régions 54 s'étendent depuis la face supérieure de la couche 44, c'est-à-dire la face la plus éloignée de la couche 38. Les régions 54 affleurent donc la face supérieure de la couche 44. Les régions 54 ne s'étendent par exemple pas jusqu'à la couche 38. Les régions 54 sont de préférence séparées de la couche 38 par la portion 52 conductrice.

La puce 36 comprend en outre des portions isolantes 56. Les portions isolantes 56 recouvrent partiellement la face supérieure de la couche 44. La puce 36 comprend en outre une piste conductrice 58 située sur la face supérieure de la couche 44 et de certaines portions 56. La piste 58 s'étend en particulier sur la face supérieure de la région 50, et plus précisément sur la couche supérieure de l'empilement du condensateur 18. De préférence, la piste 58 recouvre entièrement la face supérieure de la couche supérieure de l'empilement. La piste 58 permet la connexion entre une électrode du condensateur 18 et des éléments externes.

La portion 52 d'une région 46, en contact avec la couche inférieure du condensateur, permet la connexion entre une autre électrode du condensateur et des éléments externes à la puce. La région 46 comprenant la portion 52 s'étend par exemple autour des régions 50 et 54. La région 46 comprenant la portion 52 est en contact avec une piste 42.

La piste 58 est reliée électriquement, de préférence est en contact avec, une région 46. Par exemple, ladite région 46 est séparée du condensateur 18 par une région 48, au moins une partie de la région 46 en contact avec la couche inférieure de l'empilement, et une région 54. Les régions 46 en regard desquelles la piste 58 s'étend sont recouvertes par des portions 56. Ainsi, la piste 58 est entièrement séparée des régions 46 en regard desquelles la piste 58 s'étend par une ou plusieurs portions isolante 56.

Les figures 3 à 8 illustrent des étapes, de préférence successives, d'un mode de mise en oeuvre du procédé de la figure 1. Plus précisément, les figures 3 à 8 illustrent des étapes, de préférence successives, d'un mode de mise en oeuvre d'un procédé de fabrication du dispositif de la figure 2.

La figure 3 représente une étape d'un mode de mise en oeuvre du procédé de la figure 1. Plus précisément, la figure 3 représente une étape de fabrication de la puce 36.

Au cours de cette étape, la couche 38 est formée sur un support 60, plus précisément sur une face supérieure du support 60. La couche 38 est en un matériau isolant, par exemple en oxyde de silicium. La couche 38 recouvre de préférence, lors de sa formation, toute la face supérieure du support 60.

Le support 60 est par exemple un substrat semiconducteur. Le support 60 est par exemple en un matériau gravable sélectivement par rapport aux matériaux de la couche 38 et des pistes 42. La face supérieure du support 60 est de préférence plane.

L'étape de la figure 3 comprend en outre la formation des pistes 42 dans la couche 38. Par exemple, des cavités traversant la couche 38, c'est-à-dire atteignant le support 60, sont formées dans la couche 38 aux emplacements des pistes 42 et sont remplies par le matériau des pistes 42.

L'étape de la figure 3 comprend aussi la formation des éléments 43. Les éléments 43 sont en un matériau isolant, de préférence en le même matériau que la couche 38. Par exemple, les éléments 43 sont formés sur la face supérieure de la couche 38.

L'étape de la figure 3 comprend en outre la formation d'une couche 62 en un matériau conducteur anodisable, de préférence en métal. La couche 62 est par exemple en aluminium, ou en tantale. La couche 62 est en le matériau des régions 46.

La couche 62 ne comprend de préférence pas, lors de son dépôt, de cavités. De préférence, les faces inférieure et supérieure de la couche 62, c'est-à-dire la couche la plus proche de la couche 38 et la couche la plus éloignée de la couche 38, sont planes et parallèles. La couche 62 est par exemple en aluminium.

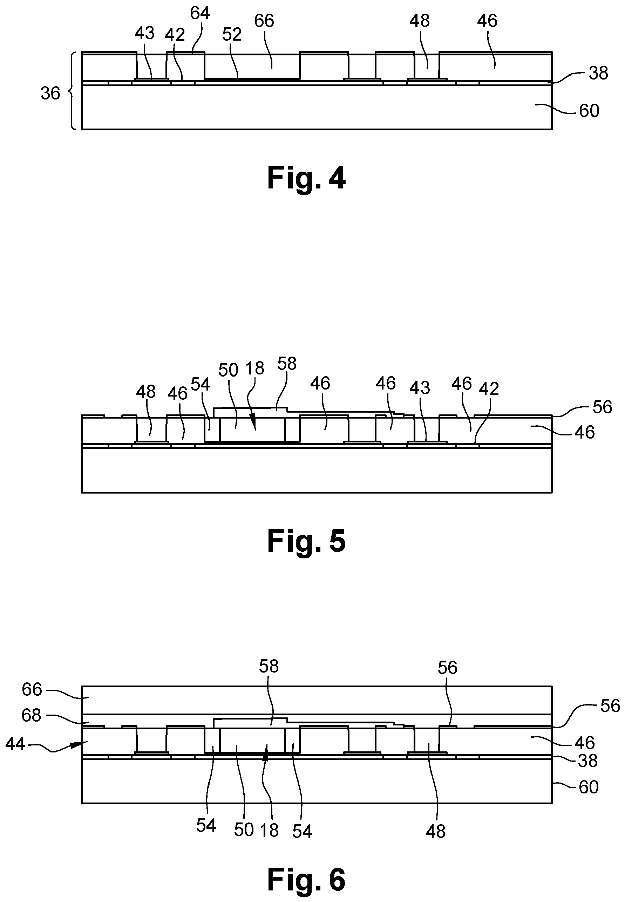

La figure 4 représente une autre étape d'un mode de mise en oeuvre du procédé de la figure 1.

Au cours de cette étape, un masque 64 est formé sur la face supérieure de la couche 62. Le masque 64 est par exemple en le même matériau que les portions 56. Le masque 64 comprend des ouvertures en regard des emplacements des régions 48, 50 et 54.

L'étape de la figure 4 comprend en outre la formation des nanopores aux emplacements des régions 48, 50 et 54. Plus précisément, l'étape de la figure 4 comprend par exemple la formation de nanopores de manière à former les régions 48 et une région 68 correspondant aux emplacements des régions 50 et 54. Pour une question de clarté, les nanopores ne sont pas représentées.

De manière à former des nanopores dans les régions 48 et 68, les portions de la couche 62 correspondant aux régions 48 et 68 subissent un procédé d'oxydation anodique, permettant de réaliser une couche isolante nanostructurée.

L'anodisation, ou procédé d'oxydation anodique, est un procédé électrolytique se déroulant en milieu humide. Le principe repose sur l'application d'une différence de potentiel imposée entre deux électrodes conductrices plongées dans une solution électrolytique, pouvant par exemple être acide. Dans l'exemple du procédé des figures 3 à 8, une des électrodes conductrices, par exemple l'anode, est la couche 62. L'application d'un potentiel à une électrode induit une croissance d'alumine à sa surface si l'électrode est en aluminium. La dissolution de l'électrode en aluminium dans le bain d'acide provoque l'apparition de nanopores ou de cavités dans la surface de l'électrode.

Les nanopores ont par exemple avantageusement un diamètre de l'ordre de 80 nm et sont espacés de 50 nm. La densité de nanopores est par exemple 40 cavités/µm². De plus, le procédé d'anodisation utilisé permet l'obtention de nanopores débouchant sur la couche 62. En d'autres termes, les nanopores peuvent être considérés comme des nano-cylindres dont un coté débouche sur la couche 52.

Le procédé de formation de nanopores est effectué de telle manière que les nanopores atteignent les éléments 43 dans les régions 48 et n'atteignent pas la couche 38 dans la région 68. Ainsi, la portion 52 est formée sous la région 68.

La figure 5 représente une autre étape d'un mode de mise en oeuvre du procédé de la figure 1.

Le procédé de la figure 5 comprend la formation de l'empilement de couches du condensateur 18. Plus précisément, le condensateur 18 comprend un empilement d'une couche métallique inférieure, d'une couche isolante et d'une couche métallique supérieure formées de manière conforme dans la région 50, comme décrit en relation avec la figure 2.

Ainsi, la couche inférieure de l'empilement du condensateur 18 s'étend de manière conforme sur la structure à nanopores, et en particulier à l'intérieur des nanopores de la région 50. La couche inférieure du condensateur 18 recouvre dans la région 50, de préférence entièrement, la face supérieure de la couche 44, les parois latérales des nanopores, et le fond des nanopores. La couche inférieure du condensateur 18 affleure ainsi la face supérieure de la portion 52. La couche inférieure du condensateur 18 est donc reliée électriquement, de préférence en contact, avec une région 46 par l'intermédiaire de la portion 52 située sous le condensateur 18.

La couche intermédiaire de l'empilement du condensateur 18 s'étend de manière conforme sur la couche inférieure. La couche intermédiaire s'étend dans les nanopores. La couche intermédiaire recouvre de préférence entièrement la couche inférieure.

La couche supérieure de l'empilement du condensateur 18 s'étend de manière conforme sur la couche intermédiaire. La couche supérieure s'étend dans les nanopores. La couche supérieure remplit par exemple les nanopores. La couche supérieure recouvre de préférence entièrement la couche intermédiaire. La couche supérieure comprend par exemple une face supérieure plane s'étendant au-dessus de la face supérieure de la structure à nanopores dans la région 50.

L'étape de la figure 5 comprend en outre la formation des portions de matériau isolant 56. Les portions 56 sont par exemple obtenue à partir du masque 64, par exemple en gravant des ouvertures aux emplacements où les portions 56 ne sont pas présentes. Alternativement, le masque 64 peut être retiré et remplacé par les portions 56.

L'étape de la figure 5 comprend en outre la formation de la piste 58.

La figure 6 représente une autre étape d'un mode de mise en oeuvre du procédé de la figure 1.

Au cours de cette étape, une poignée 66 est fixée sur la puce 36. La poignée 66 est fixée à la face supérieure de la puce 36, c'est-à-dire la face opposée au support 60.

La poignée 66 et fixée à la puce 36 par une couche de matériau de fixation par exemple une couche de colle temporaire 68. La couche de colle temporaire 68 est située sur la face supérieure de la puce 36. Plus précisément, la couche de colle temporaire 68 est formée de manière à recouvrir toute la face supérieure de la puce 36. Les faces supérieures de la piste 58, des portions 56 et de la couche 44 sont recouvert par la couche de colle temporaire 68.

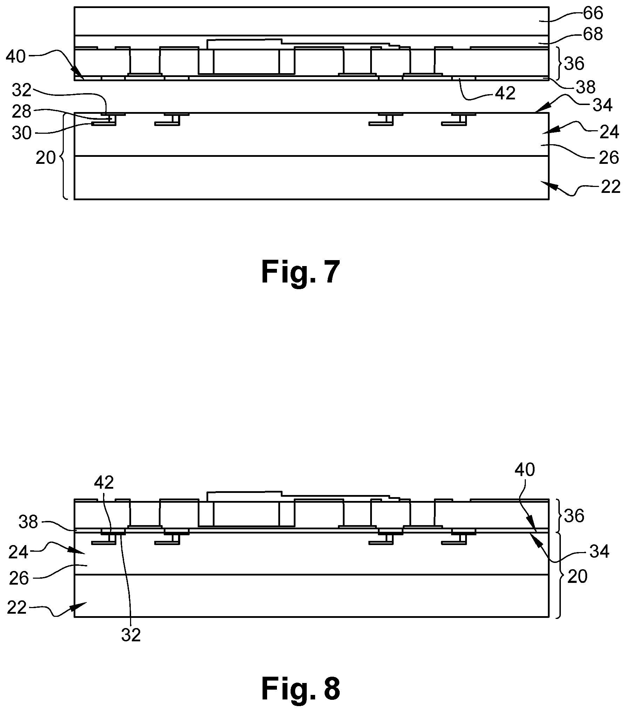

La figure 7 représente une autre étape d'un mode de mise en oeuvre du procédé de la figure 1.

Au cours de cette étape, le support 60 est retiré, par exemple par une étape de meulage, par exemple grossier puis fin, suivi d'une gravure chimique.

L'étape de la figure 7 comprend en outre la formation de la puce 20. La formation de la puce 20 peut être effectuée parallèlement ou successivement à la formation de la puce 36. Ainsi, la puce 20 est formée indépendamment de la formation de la puce 36.

La formation de la puce 20 correspond par exemple à la formation d'une puce de circuit intégré.

La formation de la puce 20 comprend la formation de composants électroniques, par exemple d'un circuit électronique, dans le substrat 22. La formation de la puce 20 comprend par exemple la formation de transistors dans le substrat 22.

La formation de la puce 20 comprend de plus la formation d'un réseau d'interconnexion 24. La formation du réseau d'interconnexion comprend la formation de couches 26 isolantes, et la formation dans les couches 26 d'un réseau de pistes conductrices 30 et de vias conducteurs 28.

La formation du réseau d'interconnexion 24 comprend en outre la formation, au niveau de la face supérieure 34 de la puce 20, c'est-à-dire la face du réseau d'interconnexion la plus éloignée du substrat 22, de pistes 32 affleurant la face supérieure du réseau 24. La face supérieure du réseau 24 est une face plane, adaptée au collage moléculaire.

La figure 8 représente une autre étape d'un mode de mise en oeuvre du procédé de la figure 1.

Au cours de cette étape, les puces 20 et 36 sont fixées l'une à l'autre par collage moléculaire hybride, par les faces planes 34 et 40. Ainsi, les pistes 32 et 42 sont placées en contact et la couche 26 supérieure de l'empilement du réseau 24 est placée en contact avec la face inférieure de la couche 38. De préférence, chaque piste 32 est placée en contact avec une piste 42.

Le collage moléculaire des puces 20 et 36 comprend une étape de recuit par exemple inférieure à 450 °C, par exemple sensiblement égale à 400 °C.

De plus, l'étape de la figure 8 comprend le retrait de la poignée 66 et de la couche de fixation 68. Le retrait de la poignée 66 et de la couche de fixation 68 peuvent être effectués avant ou après l'étape de recuit, selon la composition, et le budget thermique de la colle.

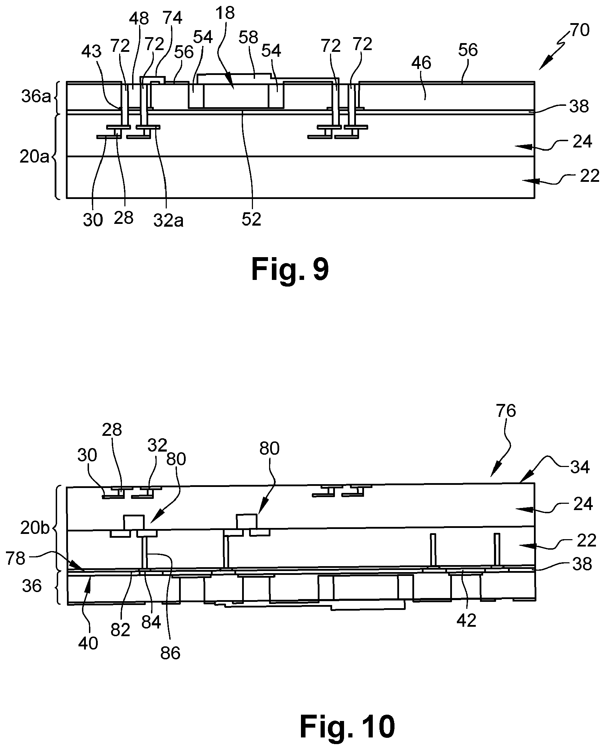

La figure 9 représente un mode de réalisation d'un autre dispositif 70 comprenant un condensateur proche d'un circuit électronique résultant d'un autre mode de mise en oeuvre.

Le dispositif 70 de la figure 9 comprend des éléments identiques au dispositif 16 de la figure 2 qui ne seront pas décrits de nouveau en détail. En particulier, le dispositif 70 comprend :
- une puce 20a, comprenant le substrat 22 dans et sur lequel sont formés des composants électroniques et le réseau d'interconnexion 24 ;
- la puce 36a, comprenant la couche isolante 38, les régions 48, 50, 54, le condensateur 18, les portions 56 et la piste 58.

Le dispositif 70 diffère du dispositif 16 de la figure 2 en ce que, dans le dispositif 70, les puces 36a et 20a sont fixées l'une à l'autre par collage oxyde/oxyde et non par collage hybride.

Ainsi, la puce 20a diffère de la puce 20 de la figure 2 en ce que la face supérieure de la puce 20a, c'est-à-dire la face supérieure du réseau 24, c'est-à-dire la face de la puce 20a la plus éloignée du substrat 22, est adaptée au collage moléculaire oxyde/oxyde. Ainsi, la couche isolante 26 supérieure du réseau 24, c'est-à-dire la couche 26 la plus éloignée du substrat, ne comprend pas les pistes 42.

Ainsi, lors de la fabrication de la puce 20a, c'est-à-dire avant l'étape de collage moléculaire des puces 20a et 36a, la face supérieure de la puce 20a est entièrement formée d'oxyde, c'est-à-dire le matériau de la couche 26.

En outre, la puce 36a diffère de la puce 36 de la figure 2 en ce que la couche 38 ne comprend pas de pistes 42. De plus, les portions 56 recouvrent par exemple toutes les régions 46.

Ainsi, lors de la fabrication de la puce 36a, c'est-à-dire avant l'étape de collage moléculaire des puces 20a et 36a, la face inférieure de la puce 20a, c'est-à-dire la face inférieure de la couche 38, est entièrement formée d'oxyde, c'est-à-dire le matériau de la couche 38.

Le dispositif 70 comprend des vias 72 conducteurs. Les vias 72 s'étendent de la puce 20a à la puce 36a. Plus précisément, chaque via 72 s'étend par exemple à partir d'une piste conductrice 32a enterrée dans le réseau 24. Une extrémité de chaque via 72 est par exemple en contact avec la face supérieure d'une piste 32a. Chaque via 72 s'étend de préférence jusqu'à la face supérieure de la puce 36a. De préférence, chaque via 72 traverse la couche 38 et un élément 43. De préférence, chaque via 72 traverse au moins partiellement, de préférence entièrement, une région 48. Chaque via 72 est ainsi séparé des régions 46 et des autres vias 72 par la couche 38, les éléments 43 et les régions 48. Les vias 72 sont reliés entre eux, aux condensateurs 18 ou à des éléments extérieurs au dispositif 70 par des éléments conducteurs. En particulier, un via 72 est relié à la piste 58. Autrement dit, une partie de la piste 58 s'étend jusqu'à, et est en contact avec, l'extrémité supérieure d'un via 72, c'est-à-dire l'extrémité affleurant la face supérieure de la région 48, c'est-à-dire l'extrémité opposée à l'extrémité située dans la puce 20a en contact avec les pistes 32a. Une première borne du condensateur 18 est ainsi reliée à un circuit de la puce 20 par l'intermédiaire de la piste 58, d'un via 72 et du réseau d'interconnexion 24.

Un autre via 72, comprenant une extrémité affleurant la face supérieure d'une région 48, est relié, par exemple par une piste conductrice 74 s'étendant sur la face supérieure de la puce 36a, à la région 46 comprenant la portion 52, c'est-à-dire la région 56 reliée à une deuxième borne du condensateur 18. Autrement dit, la piste 74, par exemple une piste métallique, est par exemple en contact avec l'extrémité du via 72 et avec la face supérieure de la région 46 comprenant la portion 52. La piste 74 traverse de préférence la portion 56 s'étendant au-dessus de la région 46 comprenant la portion 52. Dans le cas où la piste 74 s'étend au-dessus d'autres régions 46, la piste 74 est de préférence séparée des autres régions 46 par une portion 56.

Les vias 72 sont de préférence formés après l'étape de collage moléculaire. La couche supérieure 26 et la couche 38 ne comprennent de préférence pas de piste métallique, à l'exception des vias 72. Ainsi, une fois les puces 20a et 36a fixées l'une à l'autre, des cavités sont formées depuis la face supérieure de la puce 36a, de manière à atteindre les pistes 32a, et ensuite remplies de matériau conducteur.

La figure 10 représente un mode de réalisation d'un dispositif 76 comprenant un condensateur proche d'un circuit électronique résultant d'un autre mode de mise en oeuvre.

Le dispositif 76 de la figure 10 comprend des éléments identiques au dispositif 16 de la figure 2 qui ne seront pas décrits de nouveau en détail. En particulier, le dispositif 76 comprend :
- la puce 36 telle que décrite en relation avec la figure 2 ; et
- une puce 20b comprenant le réseau d'interconnexion 24 et le substrat 22.

Le dispositif 76 diffère du dispositif 16 en ce que la puce 36 n'est pas fixée sur la face supérieure 34 de la puce 20b, c'est-à-dire la face supérieure 34 du réseau d'interconnexion 24, mais sur une face inférieure 78 de la puce 20b, c'est-à-dire la face opposée à la face 34 de la puce 20b. Autrement dit, les puces 20b et 36 sont fixées l'une à l'autre par collage moléculaire hybride entre les faces 40 et 78.

La puce 20b comprend, comme la puce 20, des composants électroniques actifs. La puce 20b comprend par exemple des transistors 80 représentés schématiquement en figure 10. Les transistors 80 sont situés dans et sur le substrat 22. Ainsi, les transistors 80 comprennent des régions dans le substrat 22, par exemple des régions de source et de drain. Les transistors 80 comprennent par exemple une borne de commande située sur le substrat, par exemple sur la face supérieure du substrat, c'est-à-dire dans les couches isolantes 26 du réseau d'interconnexion.

La face 78 de la puce 20b est adapté à un collage moléculaire hybride, par exemple métal-oxyde. La puce 20b comprend une couche 82 en un matériau isolant, par exemple en oxyde de silicium, recouvrant la face inférieure du substrat 22, c'est-à-dire la face du substrat 22 la plus éloignée de la face 34. La puce 20b comprend des pistes 84 dans la couche 82. Les pistes 84 affleurent la face 78. Les pistes 84 sont situées de manière à être en contact avec les pistes 42, de manière à permettre le collage moléculaire et la liaison électrique avec la puce 36.

La puce 20b comprend des vias 86 s'étendant des pistes 84 aux composants électroniques de la puce 20b. Les vias 86 sont par exemple des vias conducteurs isolés, c'est-à-dire des vias comprenant un coeur conducteur et une gaine isolante.

La puce 20b comprend, comme la puce 20 de la figure 2, des pistes conductrices 30 enterrées dans le réseau 24, des vias conducteurs 28 et des pistes 32 affleurant la face 34 de la puce 20b. Ainsi, la puce 20b est reliée par sa face inférieure 78 au condensateur 18 et peut être reliée, par le réseau d'interconnexion 24 à d'autres éléments externes à la puce.

Selon d'autres modes de réalisation, les transistors 80 peuvent être remplacés par d'autres types de transistors.

Un avantage des modes de réalisation décrits précisément est qu'il est possible de former des condensateurs très proches de puces comprenant des circuits électroniques, séparés par exemple uniquement par un niveau de métallisation.

Un autre avantage des modes de réalisation décrits est que la fabrication des condensateurs ne risque pas de causer des dommages aux circuits électroniques. En particulier, les circuits électroniques ne subissent pas le budget thermique de la formation du condensateur, uniquement celui de la fixation des deux puces.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que les étapes décrites du procédé fassent référence à des puces, les étapes peuvent être mise en oeuvre sur une plaque de silicium (wafer) de manière à former simultanément un grand nombre de puces. Ainsi, les puces peuvent être fabriquées de manière individuelles et fixées l'une à l'autre. Selon un autre mode de réalisation, une pluralité de puces est formée simultanément dans des plaques de semiconducteur. Les puces sont ensuite individualisées et fixées les unes aux autres.

Enfin, la mise en oeuvre pratique des modes de réalisation et variantes décrits est à la portée de la personne du métier à partir des indications fonctionnelles données ci-dessus.

## Revendications

1. Dispositif comprenant des première (20, 20a, 20b) et deuxième (36, 36a) puces, la première puce (20, 20a, 20b) comprenant un circuit électronique et la deuxième puce (36, 36a) comprenant un condensateur (18) ayant une densité supérieure à 700 nF/mm^2, les première et deuxième puces étant fixées l'une à l'autre par collage moléculaire, dans lequel le condensateur (18) comprend un empilement d'une première couche isolante entre deux deuxièmes couches conductrices, l'empilement étant situé dans une première région (50) de métal anodisé.

2. Dispositif selon la revendication 1, dans lequel la première puce (20, 20a, 20b) comprend un réseau d'interconnexion (24) et un substrat semiconducteur (22) dans et sur lequel sont situés des composants (80) du circuit électronique.

3. Dispositif selon la revendication 1 ou 2, dans lequel la deuxième puce (36, 36a) comprend une troisième couche isolante (38) ayant une première face (40) plane et une deuxième face, la deuxième face étant recouverte d'une quatrième couche (36) comprenant au moins la première région (50).

4. Dispositif selon la revendication 3, dans lequel la première région (50) est entourée d'une quatrième région isolante (54) en métal anodisé.

5. Dispositif selon la revendication 3 ou 4, dans lequel la quatrième couche (36) de la deuxième puce comprend des deuxièmes régions (48) isolantes en métal anodisé et des troisièmes régions (46) en métal, les troisièmes régions (46) étant séparées par des deuxièmes régions (48).

6. Dispositif selon l'une quelconque des revendications 3 à 5, dans lequel les première (20, 20b) et deuxième (36) puces sont fixées par collage moléculaire hybride, la troisième couche isolante (38) et le réseau d'interconnexion (24) comprenant des premières pistes conductrices situées en contact les unes avec les autres.

7. Dispositif selon la revendication 6, dans lequel la face du substrat opposée au réseau d'interconnexion est recouverte par une cinquième couche isolante (82) et des deuxièmes pistes conductrices, la cinquième couche et les deuxièmes pistes conductrices étant configurées pour être fixées à la troisième couche (38) et aux premières pistes (42) par collage moléculaire.

8. Dispositif selon l'une quelconque des revendications 3 à 5, dans lequel les puces sont fixées par collage moléculaire oxyde/oxyde, le dispositif comprenant des vias (72) s'étendant dans les première (20a) et deuxième (36a) puces, traversant la troisième couche (38) et atteignant une piste conductrice (32a) enterrée dans le réseau d'interconnexion (24) .

9. Dispositif selon l'une quelconque des revendications 5 ou 6 à 8 dans son rattachement à la revendication 5, dans lequel chacune des bornes du condensateur (18) est reliée à une troisième région (46).

10. Procédé comprenant la formation d'une première puce (20, 20a, 20b) comprenant un circuit électronique, et la formation d'une deuxième puce (36, 36a) comprenant un condensateur (18) ayant une densité supérieure à 700 nF/mm^2, le procédé comprenant en outre la fixation des première (20, 20a, 20b) et deuxième puces par collage moléculaire, dans lequel le condensateur (18) comprend un empilement d'une première couche isolante entre deux deuxièmes couches conductrices, l'empilement étant situé dans une première région (50) de métal anodisé.

11. Procédé selon la revendication 10 appliqué à la fabrication d'un dispositif selon l'une quelconque des revendications 1 à 9.

12. Procédé selon la revendication 11 dans son rattachement à la revendication 3 ou 4, comprenant la formation, sur un support (60), de la troisième couche isolante (38) et d'une couche de métal anodisable.

13. Procédé selon la revendication 12 dans son rattachement à la revendication 5, comprenant l'anodisation de la couche métallique aux emplacements des première (50) et deuxième régions (48).

14. Procédé selon l'une quelconque des revendications 11 à 13 dans son rattachement à la revendication 3, comprenant la fixation de la première puce (20, 20a, 20b) à une poignée (66) et le retrait du support (60) de manière à découvrir la face plane de la troisième couche (38).

15. Procédé selon l'une quelconque des revendications 11 à 14 dans son rattachement à la revendication 8, dans lequel les vias (72) sont formés après la fixation des première et deuxième puces.
